# EUROPEAN PATENT APPLICATION

(11) **EP 1 150 171 A2**
(43) Date of publication of application: **31.10.2001**
(21) Application number: 01109861.3
(22) Date of filing: 23.04.2001
(51) Int. Cl.: G03F 7/20, G03F 1/00, G03F 1/14

(54) **Group connection of reticle sub-shapes to reduce line shortening and improve pattern fidelity**

(30) Priority: 28.04.2000 US 561581
(71) Applicant: Infineon Technologies North America Corp., San Jose, CA 95112-6000 (US); International Business Machines Corporation, Armonk, NY 10504 (US)
(72) Inventor: Kunkel, Gerhard, 01445 Radebeul (DE); Schulze, Steffen, Wappingers Falls, NY 12590 (US); Butt, Shahid, Ossining, NY 10562 (US); Bukofsky, Scott, Hopewell Junction, NY 12533 (US); Preuninger, Juergen, Wappingers Falls, NY 12590 (US)
(74) Representative: Epping Hermann & Fischer

(57) **Abstract**

The problem of line shortening which occurs during the photo lithographic processes can be reduced by dividing images on masks to be printed into multiple sub images. The sub images are spread to an optimized distance apart so that the printed image matches the original desired dimensions.

## Description

### BACKGROUND OF THE INVENTION

### Field of the Invention

The present invention generally relates to computer chip manufacture, and more specifically to imaging features on a mask.

### Background Description

As is well known, photolithography methods have been used for patterning a resist layer on a semiconductor wafer to form integrated circuits (ICs) such as microprocessors and dynamic random access memory (DRAM). As the ICs on the semiconductor wafer become smaller in dimensions, the photolithography method is gaining more importance.

Presently, one of the most conventional photo lithography methods used nowadays is a stepper, so called as a step-and-repeater, which images patterns from a reticle onto a wafer. The reticle comprises a transparent substrate and a pattern formed thereon. The transparent substrate is generally planar and has a high optical transmission or reflection at a desired exposure wavelength. The patterns on the transparent substrate are comprised of opaque materials, typically chrome. The reticles can comprise opaque materials other than chrome, e.g. phase-shifting materials. Since the patterns formed on the wafer are determined by the features on the reticle, the layout of the reticle features is of critical importance to the photo lithography process.

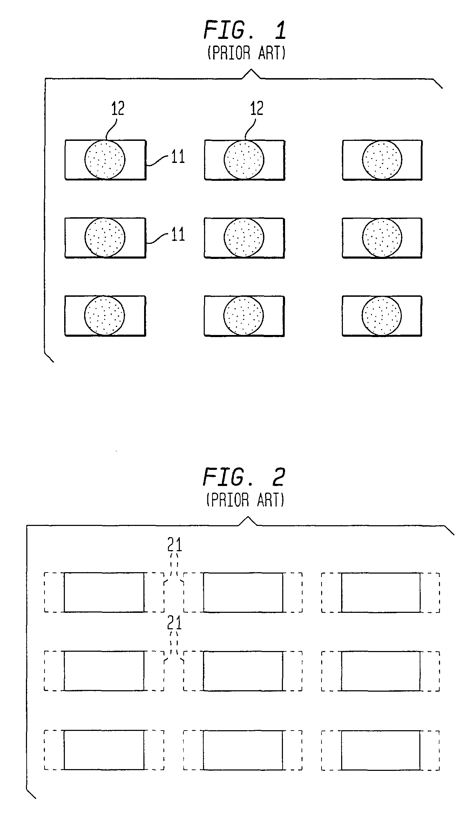

Dense arrays of rectangular features are particularly difficult to image, especially as ground rules become smaller and smaller. Figure 1 shows a schematic of a reticle pattern of densely packed rectangular clear features 11 in an opaque background. This general pattern is widely used in semiconductor devices; for example the capacitor level of a DRAM cell, the electrode pattern of a stacked-capacitor DRAM cell, and many contact levels in both DRAM and microprocessor circuits, to name a few. As can be seen, the image as printed in photo resist is a series of spaced apart ovals 12. During the typical course of processing, the exposure dose is chosen such that one critical dimension (the rectangle width in this case) is on target. Due to the features being very small and due to fundamental optical effects, the images of these designed rectangles are not rectangular at all, but oval. More importantly, due to image shortening, the desired length of the feature is difficult to achieve. In order to alleviate these problems, there are two different approaches: either altering the exposure parameters (illumination, photo resist, etc.) Or altering the mask features themselves.

It is well known in the art that biasing of shapes or optical proximity correction (OPC) can aid in improving image fidelity. These techniques involve moving the edges of the shape on the mask in such a way that the pattern images better. To compensate for image shortening effects, the edges of the mask feature are moved out to create, in effect, a larger shape on the mask which prints at the desired size after shortening is taken into account. However, as ground rules become smaller and features are packed together tighter, the efficacy of these techniques becomes less and less.

The mask-level solution well known in the art is shown in Figure 2. Here, the edges 21 of the mask features are extended to compensate for image shortening. However, as features become more closely packed together and the feature dimensions decrease, this approach fails due to insufficient space between features to move pattern edges.

### SUMMARY OF THE INVENTION

It is therefore an object of the present invention to provide a high contrast image.

It is further an object to produce image sizes as printed in photo resist as close to designed sizes as possible.

The inventive technique reduces the effects of line shortening by dividing a shape to be printed into a plurality of sub shapes. Multiple shapes on a mask may be divided at the same time.

To illustrate this invention novel pattern layouts are shown that reduce line shortening and improve the pattern fidelity.

### BRIEF DESCRIPTION OF THE DRAWINGS

The foregoing and other objects, aspects and advantages will be better understood from the following detailed description of a preferred embodiment of the invention with reference to the drawings, in which:
Figure 1 is schematic of a typical mask pattern;
Figure 2 is a schematic of a mask pattern utilizing an edge extension technique;
Figure 3 is a flow chart of the inventive process;
Figure 4 is a schematic of a resist optical lithography model of the invention; and
Figure 5 is a schematic top down view of an image resulting from the inventive mask pattern and method.

### DETAILED DESCRIPTION OF A PREFERRED EMBODIMENT OF THE INVENTION

For printing arrays it is desirable to have straight sidewalls and optimum aspect ratio, minimizing line shortening. Image fidelity needs to be increased while maximizing feature length to width ratio (aspect ratio). This is difficult to achieve at small ground rules with conventional lithography techniques.

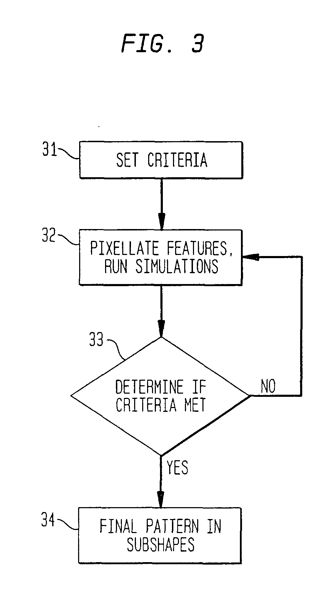

Referring now to the drawings, and more particularly to Figure 3, there is shown a flow chart illustrating the inventive process. In the first step shown in block 31, criteria such as minimum line shortening, maximum process latitude are defined. Then, as shown in block 32, the features are pixellated. Simulations are run for a given sub shape number, separation, and size. Next, as shown in block 33, a determination is made as to whether the criteria set in block 31 are met. If not, simulations are run until criteria are met. Once criteria are met, the process continues in block 34, where the final pattern is decomposed into sub shapes which when imaged reproduce the desired shape.

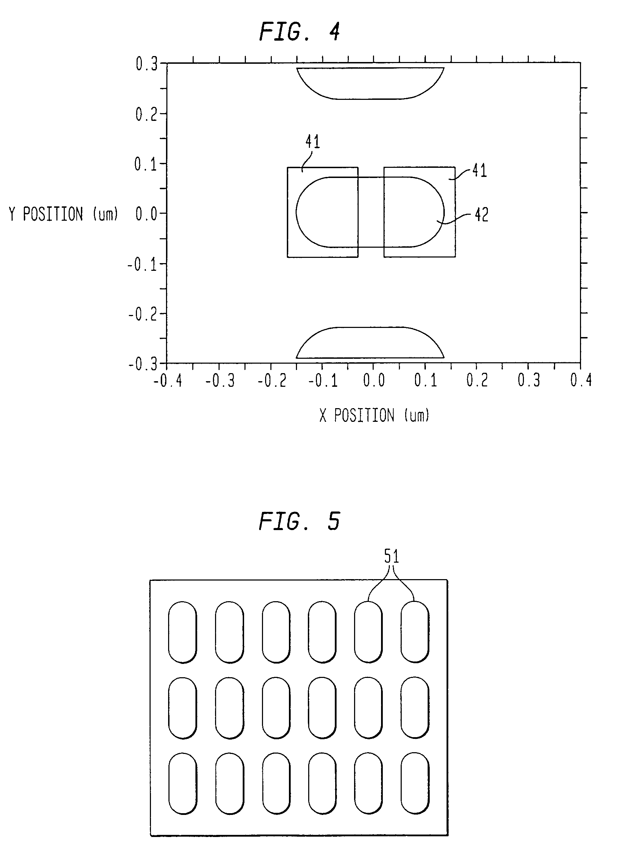

Figure 4 is a schematic of a resist optical lithography model of the invention. This schematic represents the simplest application of the inventive method. The two rectangles 41 shown are sub shapes of the originally desired shape (not shown). As described above, the sub shapes are pulled apart so that the printed image can be stretched to fill the area of the desired shape. The oval 42 resulting from processing with the sub shapes 41 has a length which reaches the total length of the rectangles together. Since the fundamental shape is altered, there is no issue with the space adjacent shapes as with the prior art.

An experimental verification of the novel shapes is shown in the schematic of Figure 5, where improved image fidelity can be observed. Figure 5 illustrates how this invention addresses the mask features. This invention goes beyond biasing and OPC by actually subdividing the shape physically on the mask. Here, a small chrome region has been introduced in the middle of the shape, dividing what was originally one shape into two. This bar is sub-resolution; that is, it does not print in the final image. By introducing these "sub-shapes", the aerial images of the two shapes can be connected such that the final image is as shown - much more rectangular and with greatly reduced line shortening. As can be seen, multiple lines 51 have been printed. Each line 51 closely approximates a rectangular shape and maintains the desired length to be printed.

This simple example can be completely generalized for any structure. One starts with a particular pattern as designed. A set of important parameters are defined, such that they capture what is most desirable to have in the final printed image. Examples might be minimum line shortening, largest process latitude, minimum sensitivity to lens aberrations, etc. The pattern can then be pixellated and processed through a simulation engine which breaks down the initial pattern into a plurality of sub shapes, and then optimizes the pattern to achieve the results desired, based upon the parameters defined above. This would be an iterative process which in the end would produce a new mask pattern decomposed into a plurality of sub-shapes, which when printed produce an optimum image. Examples of mask types which may be used in this process include attenuated phase shift, alternating phase shift, and chrome-on-glass.

There are two levels of the invention. First, the non-obvious fact that it can be beneficial to physically break up individual features and recombine them during an exposure process. Secondly, the generalization of the technique to automatically generate the optimum number, size, and separation of sub shapes based on a set of input criteria, as shown in the flow chart.

While the invention has been described in terms of a single preferred embodiment, those skilled in the art will recognize that the invention can be practiced with modification within the spirit and scope of the appended claims.

## Claims

1. A photo lithographic method comprising:
providing a mask to be imaged on photo resist;
said mask having at least one shape for printing on said photo resist;
defining a set of criteria for a final image;
choosing a critical dimension of said shape;
setting an exposure dose to match said critical dimension;
dividing said shape into a multiplicity of sub shapes;
optimizing a separation and size of said sub shapes; and
printing said mask on said photo resist.

2. A photo lithographic method as in claim 1 wherein said step of optimizing a separation comprises:
running a simulation for a given separation;
comparing a result of said simulation to said criteria; and
repeating said steps of running a simulation and comparing a result until said criteria match said result.

3. A photo lithographic method as in claim 1 wherein said mask is selected from the group consisting of attenuated phase shift, alternating phase shift, and chrome-on-glass.

4. A photo lithographic method as in claim 1, wherein said mask is an alternating phase shift mask and wherein said step of optimizing includes optimizing size and separation of sub-shapes differing transmission and phase.
